# EUROPÄISCHE PATENTSCHRIFT

(11) **EP 1 732 223 B1**
(45) Veröffentlichungstag und Bekanntmachung des Hinweises auf die Patenterteilung: **13.06.2007**
(21) Anmeldenummer: 06011556.5
(22) Anmeldetag: 03.06.2006
(51) Int. Cl.: H03K 17/16

(54) **Integrieter Schaltkreis**
Integrated circuit
Circuit intégré

(30) Priorität: 10.06.2005 DE 102005028128
(43) Veröffentlichungstag der Anmeldung: 13.12.2006
(73) Patentinhaber: ATMEL Germany GmbH, 74072 Heilbronn (DE)
(72) Erfinder: Rebholz-Goldmann, Peter, 74196 Neuenstadt (DE)

(56) Entgegenhaltungen:
- US-A- 5 289 051
- US-A- 6 160 416
- US-A1- 2001 040 470
- US-A1- 2004 021 498
- US-B2- 6 850 100

## Beschreibung

Die Erfindung betrifft einen integrierten Schaltkreis mit einem MOS-Endstufentransistor nach dem Oberbegriff des Anspruchs 1.

Derartige integrierte Schaltkreise werden beispielsweise im Bereich von Feldbussystemen verwendet. Eine Busleitung des Feldbussystems ist hierbei beispielsweise mit einer Drain-Elektrode des Endstufentransistors verbunden und eine Source-Elektrode des Endstufentransistors ist mit Masse verbunden. Die Busleitung wird über einen Pull-Up-Widerstand mit einer Betriebsspannung verbunden. Wenn alle Teilnehmer des Bussystems ihren jeweiligen Endstufentransistor derart ansteuern, dass er sperrt, liegt auf der Busleitung die Betriebsspannung an. Wenn mindestens einer der Teilnehmer seinen jeweiligen Endstufentransistor durchschaltet, liegt auf der Busleitung das Massepotential an.
Da üblicherweise die Betriebsspannung des Bussystems größer als eine Versorgungsspannung der Busteilnehmer ist, wird die Busleitung nicht direkt mit einem Busteilnehmer bzw. dessen Steuereinheit, beispielsweise einem Mikroprozessor, verbunden. Die Steuereinheit stellt hierbei lediglich ein Ansteuersignal auf ihrem Versorgungsspannungsniveau zur Verfügung, das ein Einschalten bzw. ein Ausschalten des Endstufentransistors bewirkt, und legt das Ansteuersignal an einen Steueranschluss des integrierten Schaltkreises an.

Zum Umschalten eines Schaltzustandes des Endstufentransistors sind üblicherweise ein Ladetransistor und ein Entladetransistor vorgesehen, welche die Gate-Elektrode des Endstufentransistors zum Umschalten bzw. Umladen einer Gatespannung mit einem Ladestrom bzw. einem Entladestrom beaufschlagen. Eine Ladestromquelle ist hierzu in Serie mit dem Ladetransistor zwischen die Versorgungsspannung und die Gate-Elektrode und der Entladetransistor ist in Serie mit einer Entladestromquelle zwischen die Gate-Elektrode und Masse eingeschleift. Die Stromquellen liefern während eines Umladevorgangs einen im wesentlichen konstanten Strom, wodurch sich in etwa konstante Signaländerungsgeschwindigkeiten bzw. Schaltflanken ergeben.

Die durch ein Umschalten des Endstufentransistors auf der Busleitung hervorgerufenen Signalverläufe müssen üblicherweise gewisse, in einer Busspezifikation festgeschriebene Randbedingungen erfüllen. Hierzu zählen beispielsweise eine Signalanstiegsgeschwindigkeit oder eine Signalreduktionsgeschwindigkeit, die auch als Slewrate bezeichnet werden, und Umschaltzeitdauern von einem Low- auf einen High-Pegel bzw. von einem High- auf einen Low-Pegel des Bussignals, die idealerweise in etwa gleich groß sein sollen. Gleichzeitig sollte eine Zeitverzögerung zwischen dem durch die Steuereinheit bereitgestellten Ansteuersignal und dem zugehörigen Bussignal möglichst gering sein.

In der DE 41 31 783 C1 ist eine gattungsgemäße Schaltungsanordnung zum Ansteuern eines MOS-Leistungstransistors mit geschalteten Hilfsstromquellen zur Bereitstellung eines zuätzlichen Lade- bzw. Entladestroms offenbart.

Aus der DE 198 55 604 C1 ist ein Verfahren und eine Vorrichtung zum Ansteuern einer Leistungsendstufe bekannt, bei dem ein Leistungstransistor mit unterschiedlichen Ladestromstärken geladen bzw. entladen wird.

Aus der US 2004/0021498 A1 ist ein Halbleiterschaltelement bekannt, mit einem MOS-Endstufentransistor, einem Steueranschluss zum Anlegen eines Ansteuersignals, das ein Einschalten und ein Ausschalten des Endstufentransistors steuert, mehreren schaltbaren Ladestromquellen, die eine Gate-Elektrode des Endstufentransistors mit einem veränderlichen Ladestrom beaufschlagen, mehreren schaltbaren Entladestromquellen, die beim Ausschalten des Endstufentransistors die Gate-Elektrode des Endstufentransistors mit einem veränderlichen Entladestrom beaufschlagen, einer Ausschaltsteuereinheit, die beim Ausschalten des Endstufentransistors die Gate-Elektrode während eines ersten Zeitintervalls mit einem zusätzlichen Entladestrom beaufschlagt und im Anschluss an das erste Zeitintervall den zusätzlichen Entladestrom abschaltet, wobei die Ausschaltsteuereinheit eine Spannungsbestimmungseinheit zur Bestimmung der Spannung an der Drain-Elektrode des Endstufentransistors aufweist, die ein von der an der Drain-Elektrode des Endstufentransistors anstehenden Spannung abhängiges Drainspannungssignal ausgibt. Weiterhin ist eine Ausschaltsteuerlogikeinheit vorgesehen, die das Ansteuersignal und das Drainspannungssignal empfängt und in Abhängigkeit davon ein Entladestromsteuersignal erzeugt.

Der Erfindung liegt daher die Aufgabe zugrunde, einen integrierten Schaltkreis der eingangs genannten Art bereitzustellen, der eine geringe Verzögerung zwischen dem durch die Steuereinheit bereitgestellten Ansteuersignal und dem zugehörigen Bussignal und definierte Schaltflanken aufweist.

Die Erfindung löst dieses Problem durch die Bereitstellung eines integrierten Schaltkreises nach Anspruch 1.

Erfindungsgemäß ist hierzu eine Ausschaltsteuereinheit vorgesehen, die beim Ausschalten des Endstufentransistors die Gate-Elektrode während eines ersten Zeitintervalls mit einem zusätzlichen Entladestrom beaufschlagt und im Anschluss an das erste Zeitintervall den zusätzlichen Entladestrom abschaltet. Der zusätzliche Strom bewirkt ein schnelleres Entladen der Gate-Elektrode bzw. von Kapazitäten, die zwischen der Gate-Elektrode und anderen Bereichen des Transistors bestehen, beispielsweise einer Gate-Drain-Kapazität oder einer Gate-Source-Kapazität. Dies verringert die Verzögerungszeit zwischen dem Ansteuersignal und dem zugehörigen Bussignal.

Die Ausschaltsteuereinheit weist eine Spannungsbestimmungseinheit zur Bestimmung der Spannung an der Drain-Elektrode des Endstufentransistors, die ein von der an der Drain-Elektrode des Endstufentransistors anstehenden Spannung abhängiges Drainspannungssignal ausgibt, eine Ausschaltsteuerlogikeinheit, die das Ansteuersignal und das Drainspannungssignal empfängt und in Abhängigkeit davon ein Entladestromsteuersignal erzeugt, ein durch das Entladestromsteuersignal angesteuertes Übertragungsgatter und einen bipolaren Schnellentladetransistor auf, wobei das Übertragungsgatter in Serie mit der Kollektor-Emitter-Strecke des Schnellentladetransistors zwischen die Gate-Elektrode des Endstufentransistors und ein Bezugspotential, insbesondere Masse, eingeschleift ist. Dies ermöglicht ein Zu- bzw. Abschalten eines durch das Übertragungsgatter und den Schnellentladetransistor fließenden zusätzlichen Entladestroms in Abhängigkeit vom Schaltzustand bzw. der Drainspannung des Endstufentransistors. Wenn der Endstufentransistor ausgeschaltet werden soll, wird zunächst die Gate-Elektrode mit maximaler Stromstärke entladen, d.h. die Ausschaltsteuerlogikeinheit gibt ein Entladestromsteuersignal derart aus, dass das Übertragungsgatter transparent und der Schnellentladetransistor leitend wird, so dass über diesen Pfad Ladung von der Gate-Elektrode des Endstufentransistors abfließen kann. Dies soll jedoch nur während des ersten Zeitintervalls erfolgen, d.h. beispielsweise bis zu einem Zeitpunkt, an dem an der Drain-Elektrode des Endstufentransistors in etwa ein Versorgungsspannungspegel anliegt. Bei Überschreiten dieses Spannungspegels - dies wird durch die Spannungsbestimmungseinheit detektiert - wird das Übertragungsgatter durch die Ausschaltsteuerlogikeinheit gesperrt, so dass kein Ladungsabfluss über diesen Pfad mehr stattfinden kann.

Die Spannungsbestimmungseinheit weist einen ersten Sensortransistor, dessen Gate-Elektrode mit der Versorgungsspannung verbunden ist, und eine erste Sensorstromquelle auf, wobei die Drain-Source-Strecke des ersten Sensortransistors und die erste Sensorstromquelle in Serie zwischen die Drain-Elektrode des Endstufentransistors und ein Bezugspotential, insbesondere Masse, eingeschleift sind, und das Drainspannungssignal an der Source-Elektrode des ersten Sensortransistors ansteht. Auf diese Weise kann einfach ein Drainspannungssignal zur Auswertung durch die Ausschaltsteuerlogikeinheit gewonnen werden, wobei das Drainspannungssignal aufgrund der an der Gate-Elektrode des ersten Sensortransistors anliegenden Versorgungsspannung einen Versorgungsspannungspegel abzüglich einer Schwellspannung des ersten Sensortransistors nicht überschreiten kann, auch wenn die an der Drain-Elektrode des Endstufentransistors anstehende Spannung größer als dieser Wert wird.

In einer Weiterbildung des integrierten Schaltkreises nach Anspruch 2 ist eine Einschaltsteuereinheit vorgesehen, die beim Einschalten des Endstufentransistors die Gate-Elektrode während eines zweiten Zeitintervalls mit einem zusätzlichen Ladestrom beaufschlagt und im Anschluss an das zweite Zeitintervall den zusätzlichen Ladestrom abschaltet. Bevorzugt weist die Einschaltsteuereinheit nach Anspruch 3 eine Schaltzustandsbestimmungseinheit zur Bestimmung des Schaltzustands des Endstufentransistors, die ein vom Schaltzustand des Endstufentransistors abhängiges Schaltzustandssignal ausgibt, eine Einschaltsteuerlogikeinheit, die das Ansteuersignal und das Schaltzustandssignal empfängt und in Abhängigkeit davon ein Ladestromsteuersignal erzeugt, und einen durch das Ladestromsteuersignal angesteuerten Schnellladetransistor zur Bereitstellung des zusätzlichen Ladestroms auf, der zwischen eine Versorgungsspannung und die Gate-Elektrode des Endstufentransistors eingeschleift ist. Dies ermöglicht ein Abschalten des zusätzlichen Ladestroms in Abhängigkeit vom Schaltzustand des Endstufentransistors. Wenn der Endstufentransistor eingeschaltet werden soll, wird zunächst die Gate-Elektrode mit maximaler Stromstärke geladen. Hierzu gibt die Einschaltsteuerlogikeinheit das Ladestromsteuersignal derart an den Schnellladetransistor aus, dass dieser leitend ist bzw. wird, wodurch der zusätzliche Ladestrom aktiviert wird. Dies soll jedoch nur während des zweiten Zeitintervalls erfolgen, d.h. beispielsweise bis zu einem Zeitpunkt, an dem der Endstufentransistor beginnt leitfähig zu werden. Bis zu diesem Zeitpunkt findet praktisch noch keine Änderung des am Drain-Anschluss des Endstufentransistors anstehenden Signals statt. Bei beginnender Leitfähigkeit des Endstufentransistors, die durch die Schaltzustandsbestimmungseinheit detektiert und an die Einschaltsteuerlogikeinheit ausgegeben wird, gibt die Einschaltsteuerlogikeinheit das Ladestromsteuersignal derart an den Schnellladetransistor aus, dass dieser sperrt, wodurch der zusätzliche Ladestrom abgeschaltet wird. Die Gate-Elektrode des Endstufentransistors wird dann ausschließlich durch den Ladetransistor geladen. Auf diese Weise kann eine Umschaltverzögerung verringert werden, ohne dass sich eine Flankensteilheit des Umschaltsignals ändert.

In einer Weiterbildung des integrierten Schaltkreises nach Anspruch 4 weist die Schaltzustandsbestimmungseinheit einen zweiten Sensortransistor, dessen Gate-Elektrode mit der Gate-Elektrode des Endstufentransistors verbunden ist, und eine zweite Sensorstromquelle auf, wobei die zweite Sensorstromquelle in Serie mit der Drain-Source-Strecke des zweiten Sensortransistors zwischen eine Versorgungsspannung und ein Bezugspotential, insbesondere Masse, eingeschleift ist und das Schaltzustandssignal an der Drain-Elektrode des zweiten Sensortransistors ansteht. Der zweite Sensortransistor bildet den Endstufentransistor nach und ist derart ausgebildet, dass er im wesentlichen identische elektrische Eigenschaften aufweist. Dies kann beispielsweise unter anderem durch Platzieren des Sensortransistors in der Nähe des Endstufentransistors erzielt werden. Wenn eine Spannung an der Gate-Elektrode des zweiten Sensortransistors, die ebenfalls an der Gate-Elektrode des Endstufentransistors anliegt, noch nicht ausreicht, um den Sensortransistor durchzuschalten, liegt an seiner Drain-Elektrode in etwa der Versorgungsspannungspegel an. Dies ist ein Indiz dafür, dass auch der Endstufentransistor noch nicht leitfähig ist. Wenn die Spannung an der Gate-Elektrode des zweiten Sensortransistors soweit angestiegen ist, dass der zweite Sensortransistor beginnt leitfähig zu werden, d.h. der durch die zweite Sensorstromquelle eingeprägte Strom aufgrund des abnehmenden Drain-Source-Widerstands des Sensortransistors nicht mehr ausreicht, die volle Versorgungsspannung am Drain-Anschluß zu bewirken, kann auf eine beginnende Leitfähigkeit auch des Endstufentransistors geschlossen werden. Diese Information kann dazu verwendet werden, den zusätzlichen Ladestrom abzuschalten.

In einer Weiterbildung des integrierten Schaltkreises nach Anspruch 5 weist die Ausschaltsteuereinheit einen Schnellentladefreigabetransistor, eine Schnellentladefreigabetransistoransteuereinheit zur Ansteuerung des Schnellentladefreigabetransistors, die eine an der Basis-Elektrode des Schnellentladetransistors anstehende Spannung empfängt und den Schnellentladefreigabetransistor in Abhängigkeit davon durchschaltet oder sperrt, und eine Schnellentladestromquelle auf, wobei eine Drain-Source-Strecke des Schnellentladefreigabetransistors und die Schnellentladestromquelle in Serie zwischen die Basis-Elektrode des Schnellentladetransistors und ein Bezugspotential, insbesondere Masse, eingeschleift sind. Durch die Schnellentladestromquelle, die mit Hilfe des Schnellentladefreigabetransistors zu- bzw. abgeschaltet werden kann, wird die Basis-Elektrode des Schnellentladetransistors mit einem Strom beaufschlagt, der den Schnellentladetransistor leitend macht und dadurch einen Ladungstransport von der Gate-Elektrode des Endstufentransistors in Richtung des Bezugspotentials bewirkt. Auf diese Weise wird ein Entladen der Gate-Elektrode beschleunigt. Die Ansteuerung erfolgt hierbei durch die Schnellentladefreigabetransistoransteuereinheit, die den Schnellentladefreigabetransistor in Abhängigkeit von der an der Basis-Elektrode des Schnellentladetransistors anstehenden Spannung durchschaltet oder sperrt. Insgesamt wird somit ein mehrstufiger Betrieb der Ausschaltsteuereinheit möglich. In einer ersten Betriebsart ist das Entladestromsteuersignal aktiv, d.h. das durch das Entladestromsteuersignal angesteuerte Übertragungsgatter ist transparent, und die Schnellentladefreigabetransistoransteuereinheit steuert den Schnellentladefreigabetransistor durch, d.h. die Schnellentladestromquelle bewirkt, dass der Schnellentladetransistor möglichst niederohmig ist. Insgesamt führt dies zu einer maximalen Entladegeschwindigkeit der Gate-Spannung des Endstufentransistors. In einer zweiten Betriebsart bleibt das Entladestromsteuersignal aktiv, jedoch wird die Schnellentladestromquelle durch den Schnellentladefreigabetransistor deaktiviert. Dies bewirkt eine Verringerung der Entladegeschwindigkeit. Ein Wechsel zur zweiten Betriebsart kann beispielsweise dann erfolgen, wenn der Endstufentransistor gerade beginnt zu sperren. In der zweiten Betriebsart kann dann bis zu einem bestimmten Spannungspegel an der Drain-Elektrode des Endstufentransistors eine einstellbare Anstiegsgeschwindigkeit des an der Drain-Elektrode des Endstufentransistors anliegenden Signals bewirkt werden. In einer dritten Betriebsart ist das Entladestromsteuersignal deaktiv, d.h. das Übertragungsgatter ist geschlossen, und die Schnellentladestromquelle ist deaktiviert. Eine Entladung der Gate-Elektrode des Endstufentransistors erfolgt nun ausschließlich über den Entladetransistor.

In einer Weiterbildung des integrierten Schaltkreises nach Anspruch 6 weist die Ausschaltsteuereinheit einen Integrationskondensator und eine Integrationsstromquelle auf, wobei der Integrationskondensator und die Integrationsstromquelle in Serie zwischen das Drainspannungssignal und ein Bezugspotential, insbesondere Masse, eingeschleift sind, und ein Verbindungsknoten zwischen dem Integrationskondensator und der Integrationsstromquelle mit der Basis-Elektrode des Schnellentladetransistors verbunden ist. Auf diese Weise kann eine rampenförmig abnehmende Entladespannung an der Basis-Elektrode des Schnellentladetransistors erzeugt werden, wobei aufgrund der Verbindung des Integrationskondensators mit dem Drainspannungssignal ein Rückkopplungspfad zwischen der Basis-Elektrode des Schnellentladetransistors und der Drainspannung des Endstufentransistors gebildet wird und somit der Drainspannungsverlauf des Endstufentransistors vom Spannungsverlauf an der Basis-Elektrode des Schnellentladetransistors mit bestimmt wird. Aufgrund dieser Konfiguration kann die Spannungsanstiegsgeschwindigkeit bzw. die Slewrate am Ausgang des Endstufentransistors eingestellt werden, wobei diese im wesentlichen von der Stromstärke der Integrationsstromquelle und der Kapazität des Integrationskondensators bestimmt wird, d.h. durch geeignete Dimensionierung dieser Bauteile lässt sich diese Kenngröße exakt einstellen.

In einer Weiterbildung des integrierten Schaltkreises nach Anspruch 7 ist ein Pull-Down-Widerstand, der zwischen die Gate-Elektrode des Endstufentransistors und ein Bezugspotential, insbesondere Masse, eingeschleift ist, und eine Kompensationseinheit vorgesehen, die einen durch den Pull-Down-Widerstand verursachten Strom von der Gate-Elektrode zum Bezugspotential kompensiert. Der Pull-Down-Widerstand verhindert, dass in bestimmten Betriebszuständen des integrierten Schaltkreises die Gate-Elektrode des Endstufentransistors auf einem sogenannten floatenden Potential liegt, wodurch eine zu hohe Spannung an der Gate-Elektrode entstehen kann. Allerdings führt der Pull-Down-Widerstand zu einem spannungsabhängigen Strom von der Gate-Elektrode zum Bezugspotential, wodurch sich die Slewrate des Ausgangssignals gatespannungsabhängig verändert. Da die Kompensationseinheit diesen Strom kompensiert, wird ein konstanter Umladestrom in die Gate-Elektrode bzw. in eine Gate-Drain-Kapazität und eine Gate-Source-Kapazität des Endstufentransistors eingespeist, d.h. die Ausgangsspannung bzw. die Spannung an der Drain-Elektrode des Endstufentransistors ändert sich mit einer definierten Slewrate.

In einer Weiterbildung des integrierten Schaltkreises nach Anspruch 8 weist die Kompensationseinheit einen Sensorwiderstand, dessen elektrische Eigenschaften im wesentlichen mit den elektrischen Eigenschaften des Pull-Down-Widerstands übereinstimmen, eine Spannungsfolgereinheit, welche die an dem Pull-Down-Widerstand anliegende Spannung hochohmig abgreift und niederohmig an den Sensorwiderstand anlegt, eine Strommesseinheit, die den durch den Sensorwiderstand fließenden Strom misst, und eine gesteuerte Kompensationsstromquelle zur Einspeisung eines Kompensationsstromes in die Gate-Elektrode des Endstufentransistors auf. Der Sensorwiderstand bildet den Pull-Down-Widerstand hinsichtlich seiner elektrischen Eigenschaften nach. Die Spannung am Pull-Down-Widerstand wird mit Hilfe der Spannungsfolgereinheit, die als Impedanzwandler wirkt, hochohmig abgegriffen und an den Sensorwiderstand niederohmig angelegt. Der am Sensorwiderstand entstehende Strom, dessen Stromstärke der am Pull-Down-Widerstand entspricht, wird gemessen und in die Gate-Elektrode des Endstufentransistors eingespeist. Auf diese Weise kann ein durch den Pull-Down-Widerstand verursachter Strom kompensiert werden.

Vorteilhafte Ausführungsformen der Erfindung sind in den Zeichnungen dargestellt und werden nachfolgend beschrieben. Hierbei zeigen schematisch:
- Fig. 1: ein Blockschaltbild eines erfindungsgemäßen integrierten Schaltkreises,
- Fig. 2: ein detailliertes Schaltbild eines ersten Teils des integrierten Schaltkreises von Fig. 1 und
- Fig. 3: ein detailliertes Schaltbild eines zweiten Teils des integrierten Schaltkreises von Fig. 1.

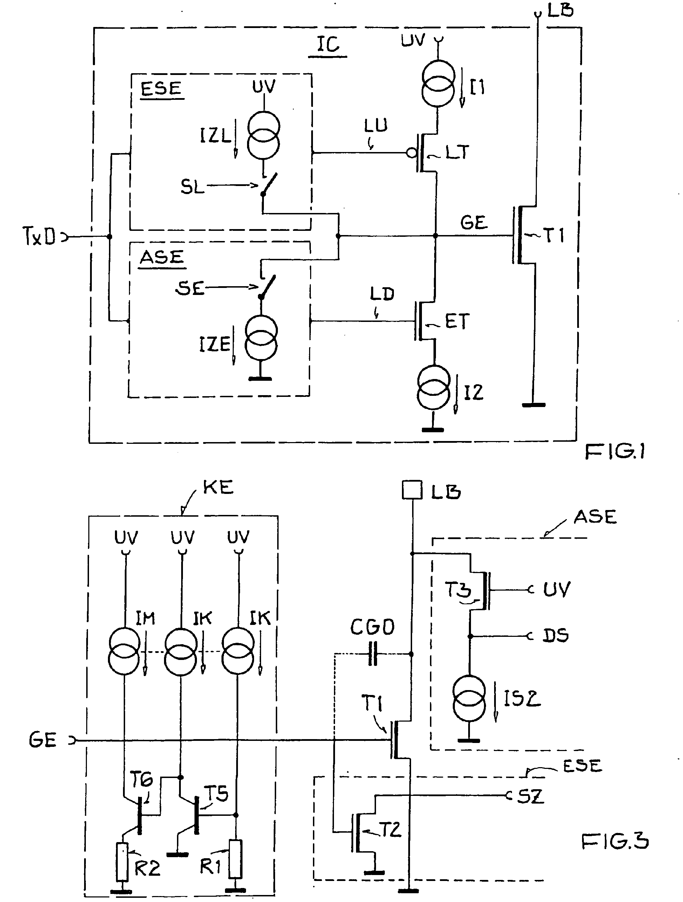

Fig. 1 zeigt ein Blockschaltbild eines integrierten Schaltkreises IC. Der integrierte Schaltkreis IC dient als Bustreiber für einen Local-Interconnect-Network(LIN)-Bus, kann jedoch durch entsprechende Anpassung auch für andere Feldbusse verwendet werden.

Der IC umfasst einen Steueranschluss TxD, an den ein Ansteuersignal anlegbar ist, das ein Einschalten und ein Ausschalten eines NMOS-Endstufentransistors T1 steuert, und einen LIN-Bus-Anschluss LB, der mit einer nicht gezeigten Busleitung verbunden werden kann. Das Ansteuersignal kann beispielsweise von einem nicht gezeigten Busteilnehmer in Form eines Mikroprozessors erzeugt werden, wobei ein Mikroprozessorausgang bzw. ein Mikroprozessorport direkt mit dem Steueranschluss TxD verbunden werden kann.

Zur Ansteuerung des Endstufentransistors T1 ist eine Einschaltsteuereinheit ESE und eine Ausschaltsteuereinheit ASE, ein PMOS-Ladetransistor LT und ein NMOS-Entladetransistor ET vorgesehen, wobei den Transistoren LT und ET noch Stromquellen I1 und I2 zugeordnet sind, die bei durchgeschalteten Transistoren LT bzw. ET einen Lade- bzw. Entladestrom bereitstellen.

Der durch ein Ladesignal LU angesteuerte Ladetransistor LT beaufschlagt beim Einschalten des Endstufentransistors T1 die Gate-Elektrode GA des Endstufentransistors T1 mit einem Ladestrom, dessen Stromstärke durch die Stromquelle I1 bestimmt wird. Der durch ein Entladesignal LD angesteuerte Entladetransistor ET beaufschlagt beim Ausschalten des Endstufentransistors T1 dessen Gate-Elektrode GA mit einem Entladestrom, dessen Stromstärke durch die Stromquelle I2 bestimmt wird.

Die Einschaltsteuereinheit ESE umfasst eine Stromquelle IZL und einen durch ein Ladestromsteuersignal SL angesteuerten Schalter S1, die in Serie zwischen eine Versorgungsspannung UV des integrierten Schaltkreises IC und die Gate-Elektrode GA des Endstufentransistors T1 eingeschleift sind. Der Schalter S1 wird derart angesteuert, dass beim Einschalten des Endstufentransistors T1 dessen Gate-Elektrode GE während eines ersten Zeitintervalls mit einem zusätzlichen Ladestrom, d.h. dem durch die Stromquelle IZL bereitgestellten Strom, beaufschlagt und im Anschluss an das erste Zeitintervall der zusätzlichen Ladestrom abschaltet wird. Der Ladetransistor LT sowie die zugehörige Stromquelle IZL sind im gezeigten Ausführungsbeispiel nicht Teil der Einschaltsteuereinheit ESE, können jedoch auch in ihr enthalten sein.

Die Ausschaltsteuereinheit ASE umfasst eine Stromquelle IZE und einen durch ein Entladestromsteuersignal SE angesteuerten Schalter S2, die in Serie zwischen die Gate-Elektrode GE des Endstufentransistors T1 und Masse eingeschleift sind. Der Schalter SE wird derart angesteuert, dass beim Ausschalten des Endstufentransistors T1 dessen Gate-Elektrode GE während eines zweiten Zeitintervalls mit einem zusätzlichen Entladestrom, d.h. dem durch die Stromquelle IZE bereitgestellten Strom, beaufschlagt und im Anschluss an das zweite Zeitintervall der zusätzliche Ladestrom abschaltet wird. Der Entladetransistor ET sowie die zugehörige Stromquelle IZE sind im gezeigten Ausführungsbeispiel nicht Teil der Ausschaltsteuereinheit ASE, können jedoch auch in ihr enthalten sein.

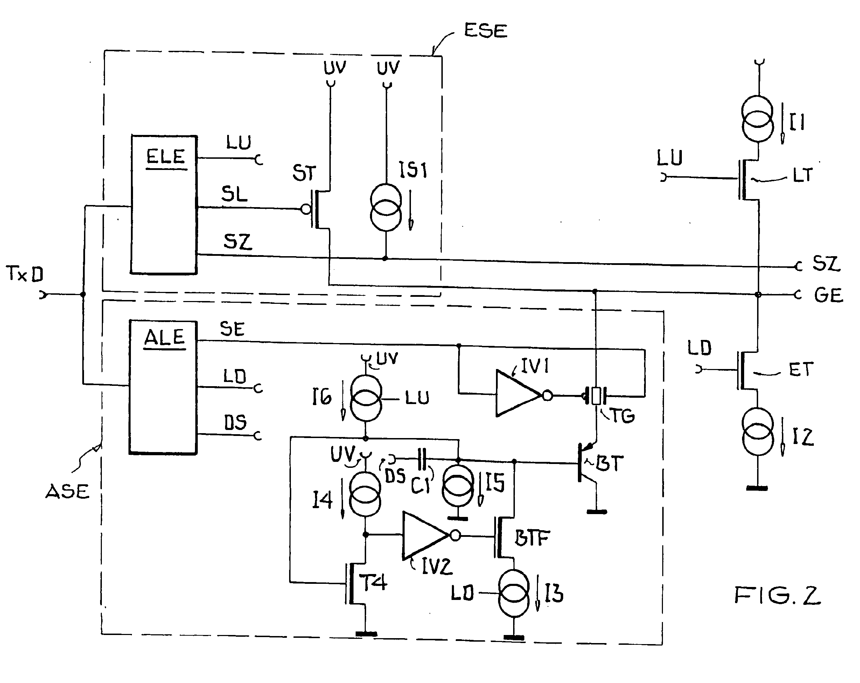

Fig. 2 und Fig. 3 zeigen jeweils detaillierte Teilschaltbilder des integrierten Schaltkreises IC von Fig. 1. Die Aufspaltung der Schaltbilder erfolgt hierbei aus Gründen der Übersichtlichkeit.

Zur Ansteuerung des Endstufentransistors T1 ist zusätzlich zu den in Fig. 1 bereits gezeigten Einheiten ESE und ASE noch eine Kompensationseinheit KE vorgesehen.

Nachfolgen wird die Funktion des in Fig. 2 und Fig. 3 gezeigten IC exemplarisch für ein Einschalten und ein anschließendes Ausschalten des Endstufentransistors T1 beschrieben.

In einem Anfangszustand ist der Endstufentransistor T1 ausgeschaltet, d.h. er sperrt. An dem LIN-Bus-Anschluss LB liegt folglich die Betriebsspannung an. Diese wird über einen nicht gezeigten Pull-Up-Widerstand angelegt, der zwischen die Betriebsspannung und die Busleitung eingeschleift ist. Die Betriebsspannung ist üblicherweise deutlich größer als die Versorgungsspannung UV des IC. Die Betriebsspannung kann beispielsweise ca. 40V und die Versorgungsspannung UV 3V bzw. 5V betragen.

Am Steueranschluss TxD wird nun ein Steuersignal angelegt, das ein Einschalten des Endstufentransistors T1 bewirken soll.

Das Steuersignal liegt jeweils an einer Einschaltsteuerlogikeinheit ELE und an einer Ausschaltsteuerlogikeinheit ALE an. Wenn das Steuersignal ein Einschalten des Endstufentransistors T1 signalisiert, deaktiviert die Ausschaltsteuerlogikeinheit ALE das Entladesignal LD und das Entladestromsteuersignal SE, wodurch die Ausschaltsteuereinheit ASE und der Entladetransistor ET deaktiviert werden, und die Einschaltsteuerlogikeinheit ELE aktiviert das Ladesignal LU. Das Ladesignal LU steuert den Ladetransistor LT durch, wodurch die Stromquelle I1 einen Grundstrom in die Gate-Elektrode GE des Endstufentransistors T1 einspeist. Das Ladestromsteuersignal SL wird in Abhängigkeit von einem Schaltzustandssignal SZ aktiviert.

Das Schaltzustandssignal SZ wird von einer Schaltzustandsbestimmungseinheit in Form eines MOS-Sensortransistors T2 und einer Sensorstromquelle IS1 erzeugt, wobei die Sensorstromquelle IS1 in Serie mit der Drain-Source-Strecke des Sensortransistors T2 zwischen die Versorgungsspannung UV und Masse eingeschleift ist und das Schaltzustandssignal SZ an der Drain-Elektrode des Sensortransistors T2 ansteht. Das Schaltzustandssignal SZ zeigt den Schaltzustand des Endstufentransistors T1 an. Wenn T1 sperrt, weist SZ einen High-Pegel auf. Wenn T1 leitet bzw. durchgeschaltet ist, weist SZ einen Low-Pegel auf. Der Sensortransistor T2 ist derart ausgebildet bzw. dimensioniert, dass er im wesentlichen gleiche elektrische Eigenschaften wie der Endstufentransistor T1 aufweist.

Die Einschaltsteuerlogikeinheit ELE aktiviert das Ladestromsteuersignal SL im gezeigten Fall, da das Schaltzustandssignal SZ einen gesperrten Endstufentransistor T1 anzeigt. Das aktivierte Ladestromsteuersignal SL steuert einen zwischen die Versorgungsspannung UV und die Gate-Elektrode GE des Endstufentransistors T1 eingeschleiften PMOS-Schnellladetransistor ST durch, wodurch ein zusätzlicher Ladestrom in die Gate-Elektrode GE von T1 eingespeist wird. Dies beschleunigt ein Laden von Gatekapazitäten, exemplarisch ist in Fig. 3 eine Gate-Drain-Kapazität CGD gezeigt, von T1, d.h. die Zeitdauer, bis T1 zu leiten beginnt, nimmt ab.

Der Transistor ST bleibt während eines ersten Zeitintervalls aktiv, bis das Schaltzustandssignal SZ eine beginnende Leitfähigkeit des Endstufentransistors T1 anzeigt. Bis zu diesem Zeitpunkt findet praktisch noch keine Änderung des am Drain-Anschluss des Endstufentransistors T1 anstehenden Signals statt. Bei beginnender Leitfähigkeit des Endstufentransistors T1 gibt die Einschaltsteuerlogikeinheit ELE das Ladestromsteuersignal SL derart an den Schnellladetransistor ST aus, dass dieser sperrt, wodurch der zusätzliche Ladestrom abgeschaltet wird. Die Gate-Elektrode GE des Endstufentransistors T1 wird anschließend ausschließlich durch den Ladetransistor LT geladen. Auf diese Weise kann eine Umschaltverzögerung verringert werden, ohne dass sich eine Flankensteilheit des Umschaltsignals ändert.

Nach erfolgtem Einschalten des Endstufentransistors T1 liegt am LIN-Bus-Anschluss LB in etwa die Massespannung an. Am Steueranschluss TxD wird nun von außen ein Steuersignal angelegt, das ein Ausschalten des Endstufentransistors T1 bewirken soll.

Die Einschaltsteuerlogikeinheit ELE deaktiviert hierauf das Ladesignal LU, wodurch der Ladetransistor LT sperrt. Das Ladestromsteuersignal SL bleibt deaktiv.

Die Ausschaltsteuerlogikeinheit ALE aktiviert das Entladesignal LD. Das Entladesignal LD steuert den Entladetransistor ET durch, wodurch die Stromquelle I2 einen Grundstrom aus der Gate-Elektrode GE des Endstufentransistors T1 in Richtung Masse ableitet. Ein Entladestromsteuersignal SE wird in Abhängigkeit von einem Drainspannungssignal DS aktiviert.

Das Drainspannungssignal DS wird von einer Spannungsbestimmungseinheit in Form eines zweiten Sensortransistors T3, dessen Gate-Elektrode mit der Versorgungsspannung UV verbunden ist, und einer zweiten Sensorstromquelle IS2 erzeugt, wobei die Drain-Source-Strecke des zweiten Sensortransistors T3 und die zweite Sensorstromquelle IS2 in Serie zwischen die Drain-Elektrode des Endstufentransistors T1 und Masse eingeschleift sind und das Drainspannungssignal DS an der Source-Elektrode des zweiten Sensortransistors T3 ansteht. Das Drainspannungssignal DS wird durch die Ausschaltsteuerlogikeinheit ALE ausgewertet, wobei das Drainspannungssignal DE aufgrund der an der Gate-Elektrode des zweiten Sensortransistors T3 anliegenden Versorgungsspannung UV einen Versorgungsspannungspegel abzüglich einer Schwellspannung des zweiten Sensortransistors T3 nicht überschreiten kann, auch wenn die an der Drain-Elektrode des Endstufentransistors T1 anstehende Spannung größer als dieser Wert wird.

Die Ausschaltsteuerlogikeinheit ALE aktiviert das Entladestromsteuersignal SE im gezeigten Fall, da das Drainspannungssignal DS eine Drainspannung des Endstufentransistors T1 anzeigt, die im Bereich der Massespannung liegt, d.h. der Endstufentransistor T1 ist durchgeschaltet. In diesem Fall soll die Gate-Elektrode des Endstufentransistors T1 während eines zweiten Zeitintervalls mit einem zusätzlichen Entladestrom beaufschlagt werden, um ein Sperren von T1 zu beschleunigen.

Das aktivierte Entladestromsteuersignal SE in Verbindung mit einem Inverter IV1 schaltet ein Übertragungsgatter TG transparent, das in Serie mit der Kollektor-Emitter-Strecke eines bipolaren npn-Schnellentladetransistors BT zwischen die Gate-Elektrode GE des Endstufentransistors T1 und Masse eingeschleift ist.

Zwischen die Basis-Elektrode des Schnellentladetransistors BT und Masse ist ein NMOS-Schnellentladefreigabetransistor BTF und eine Schnellentladestromquelle I3 eingeschleift. Die Schnellentladestromquelle I3 wird durch das Entladesignal LD angesteuert und ist nur bei aktivem Entladesignal LD aktiv. Der Schnellentladefreigabetransistor BTF wird durch eine Schnellentladefreigabetransistoransteuereinheit in Form eines NMOS-Transistors T4, dessen Gate-Elektrode mit der Basis-Elektrode des Schnellentladetransistors BT verbunden ist, einer Stromquelle I4 und eines Inverters IV2 angesteuert. Die Stromquelle I4 ist mit der Drain-Source-Strecke des Transistors T4 in Serie zwischen die Versorgungsspannung UV und Masse eingeschleift. Die Drainspannung des Transistors T4 dient als Eingangssignal für den Inverter IV2. Die Gate-Elektrode des Schnellentladefreigabetransistors BTF wird mit einem Ausgangssignal des Inverters IV2 beaufschlagt.

Ein Integrationskondensator C1 und eine Integrationsstromquelle I5 sind in Serie zwischen das Drainspannungssignal DS und Masse eingeschleift, wobei ein Verbindungsknoten zwischen dem Integrationskondensator C1 und der Integrationsstromquelle I5 mit der Basis-Elektrode des Schnellentladetransistors BT verbunden ist.

Eine durch das Ladesignal LU angesteuerte Stromquelle I6 ist zwischen die Versorgungsspannung und die Basis-Elektrode des Schnellentladetransistors BT eingeschleift. Die Stromquelle I6 ist nur bei aktivem Ladesignal aktiv.

Wie oben beschrieben, wird am Beginn des Entladevorgangs das Signal LU deaktiviert und das Signal LD aktiviert. Das Entladestromsteuersignal SE ist ebenfalls aktiv, da das Drainspannungssignal DS eine niedrige Spannung, d.h. einen durchgeschalteten Endstufentransistor T1 signalisiert. Die Stromquelle I6 lädt den Integrationskondensator C1 bei aktivem Ladesignal LU bis auf den Versorgungsspannungspegel auf. Nach dem Deaktivieren des Ladesignals LU und dem Aktivieren des Entladesignals LD wird der Integrationskondensator C1 von der Stromquelle I5 und der Schnellentladestromquelle I3 entladen, da der Schnellentladefreigabetransistor BTF zu diesem Zeitpunkt durchgeschaltet ist.

Das Durchschalten des Schnellentladefreigabetransistor BTF wird dadurch bewirkt, dass die Gatespannung des Transistors T4, die ja mit der am Integrationskondensator anliegenden Spannung identisch ist, zu diesem Zeitpunkt in etwa einen Versorgungsspannungspegel aufweist. Der Transistor T4 wird folglich durchgeschaltet. Die Drainspannung des Transistors T4 weist dann einen Low-Pegel auf. In Verbindung mit dem Inverter IV2 wird folglich der Schnellentladefreigabetransistor BTF durchgeschaltet, d.h. Schnellentladestromquelle I3 entlädt zusätzlich zum Integrationsstrom I5 den Integrationskondensator C1.

Die Gate-Elektrode GE des Endstufentransistors T1 wird nun zunächst mit maximaler Stromstärke entladen. Dies soll jedoch nur bis zu einem Zeitpunkt geschehen, an dem der Endstufentransistor T1 gerade zu sperren beginnt. Nachfolgend soll der zusätzliche Entladestrom bis zum Ablauf des zweiten Zeitintervalls nur noch durch die Integrationsstromquelle I5 bestimmt werden.

Hierzu bleibt das Entladestromsteuersignal SE aktiv, jedoch wird die Schnellentladestromquelle I3 durch den Schnellentladefreigabetransistor BTF deaktiviert. Dies bewirkt eine Verringerung der Entladegeschwindigkeit. Eine Abschaltschwelle des Schnellentladefreigabetransistors BTF wird durch geeignete Dimensionierung des Transistors T4 eingestellt. Im Verlaufe der Entladung des Integrationskondensators nimmt die Spannung an der Gate-Elektrode des Transistors T4 ab, d.h. sein Drain-Source-Widerstand nimmt zu. Die Drainspannungszunahme am Transistor T4 kann durch Dimensionierung derart eingestellt werden, dass sich ein High-Pegel an der Drain-Elektrode von T4 gerade dann einstellt, wenn der Endstufentransistor T1 zu sperren beginnt. Dies bewirkt, dass der Inverter IV2 den Schnellentladefreigabetransistor BTF bei diesem Schwellwert deaktiviert bzw. sperrt.

Bei gesperrtem Schnellentladefreigabetransistor BTF kann eine rampenförmig abnehmende Entladespannung an der Basis-Elektrode des Schnellentladetransistors BT erzeugt werden, wobei aufgrund der Verbindung des Integrationskondensators C1 mit dem Drainspannungssignal DS ein Rückkopplungspfad zwischen der Basis-Elektrode des Schnellentladetransistors BT und der Drainspannung des Endstufentransistors T1 gebildet wird und der Drainspannungsverlauf des Endstufentransistors T1 vom Spannungsverlauf an der Basis-Elektrode des Schnellentladetransistors BT mit bestimmt wird. Aufgrund dieser Konfiguration kann die Spannungsanstiegsgeschwindigkeit bzw. die Slewrate am Ausgang des Endstufentransistors T1 eingestellt werden, wobei diese im wesentlichen von der Stromstärke der Integrationsstromquelle 15 und der Kapazität des Integrationskondensators C1 bestimmt wird, d.h. durch geeignete Dimensionierung dieser Bauelemente lässt sich diese Kenngröße exakt einstellen.

Ab einem einstellbaren Pegel des Drainspannungssignals DS deaktiviert die Ausschaltsteuerlogikeinheit ALE das Entladestromsteuersignal SE.

Dies kann beispielsweise im Bereich der Versorgungsspannung abzüglich einer Schwellspannung des Transistors T3 erfolgen. Nach der Deaktivierung des Entladestromsteuersignals SE erfolgt ein Entladen der Gate-Elektrode GE von T1 nur noch durch den Entladetransistor ET in Verbindung mit der Stromquelle I2.

Die Kompensationseinheit KE umfasst einen Pull-Down-Widerstand R1, der zwischen die Gate-Elektrode des Endstufentransistors T1 und Masse eingeschleift ist, und eine Kompensationseinheit. Die Kompensationseinheit umfasst einen Sensorwiderstand R2, dessen elektrische Eigenschaften im wesentlichen mit den elektrischen Eigenschaften des Pull-Down-Widerstands übereinstimmen, eine Spannungsfolgereinheit in Form von bipolaren Transistoren T5 und T6, welche die an dem Pull-Down-Widerstand R1 anliegende Spannung hochohmig abgreift und niederohmig an den Sensorwiderstand R2 anlegt, eine Strommesseinheit IM, die den durch den Sensorwiderstand R2 fließenden Strom misst, und eine gesteuerte Kompensationsstromquelle IK zur Einspeisung eines Kompensationsstromes in die Gate-Elektrode des Endstufentransistors. Der Pull-Down-Widerstand R1 ist hier als Teil der Kompensationseinheit KE dargestellt, er kann jedoch auch außerhalb der Kompensationseinheit KE angeordnet sein.

Die Kompensationseinheit KE kompensiert einen durch den Pull-Down-Widerstand R1 verursachten Strom von der Gate-Elektrode des Endstufentransistors zu Masse.

## Patentansprüche

1. Integrierter Schaltkreis mit
- einem MOS-Endstufentransistor (T1),
- einem Steueranschluss (TxD) zum Anlegen eines Ansteuersignals, das ein Einschalten und ein Ausschalten des Endstufentransistors (T1) steuert,
- einem Ladetransistor (LT), der beim Einschalten des Endstufentransistors (T1) eine Gate-Elektrode (GE) des Endstufentransistors (T1) mit einem Ladestrom (I1) beaufschlagt,
- einem Entladetransistor (ET), der beim Ausschalten des Endstufentransistors (T1) die Gate-Elektrode (GE) des Endstufentransistors (T1) mit einem Entladestrom (I2) beaufschlagt, und
- einer Ausschaltsteuereinheit (ASE), die beim Ausschalten des Endstufentransistors (T1) die Gate-Elektrode (GE) während eines ersten Zeitintervalls mit einem zusätzlichen Entladestrom (IZE) beaufschlagt und im Anschluss an das erste Zeitintervall den zusätzlichen Entladestrom (IZE) abschaltet, wobei die Ausschaltsteuereinheit (ASE) aufweist:
- eine Spannungsbestimmungseinheit (T3, IS2) zur Bestimmung der Spannung an der Drain-Elektrode des Endstufentransistors (T1), die ein von der an der Drain-Elektrode des Endstufentransistors anstehenden Spannung abhängiges Drainspannungssignal (DS) ausgibt, wobei die Spannungsbestimmungseinheit aufweist:
- einen ersten Sensortransistor (T3), dessen Gate-Elektrode mit einer Versorgungsspannung (UV) verbunden ist, und
- eine erste Sensorstromquelle (lS2), wobei die Drain-Source-Strecke des ersten Sensortransistors (T3) und die erste Sensorstromquelle (IS2) in Serie zwischen die Drain-Elektrode des Endstufentransistors und ein Bezugspotential, insbesondere Masse, eingeschleift sind und das Drainspannungssignal (DS) an der Source-Elektrode des ersten Sensortransistors (T3) ansteht,
- eine Ausschaltsteuerlogikeinheit (ALE), die das Ansteuersignal und das Drainspannungssignal (DS) empfängt und in Abhängigkeit davon ein Entladestromsteuersignal (SE) erzeugt,
- ein durch das Entladestromsteuersignal angesteuertes Übertragungsgatter (TG) und
- einen bipolaren Schnellentladetransistor (BT), wobei das Übertragungsgatter (TG) in Serie mit der Kollektor-Emitter-Strecke des Schnellentladetransistors (BT) zwischen die Gate-Elektrode des Endstufentransistors und ein Bezugspotential, insbesondere Masse, eingeschleift ist.

2. Integrierter Schaltkreis nach Anspruch 1, **gekennzeichnet durch** eine Einschaltsteuereinheit (ESE), die beim Einschalten des Endstufentransistors (T1) die Gate-Elektrode (GE) während eines zweiten Zeitintervalls mit einem zusätzlichen Ladestrom (IZL) beaufschlagt und im Anschluss an das zweite Zeitintervall den zusätzlichen Ladestrom (IZL) abschaltet.

3. Integrierter Schaltkreis nach Anspruch 2, **dadurch gekennzeichnet, dass** die Einschaltsteuereinheit aufweist:
- eine Schaltzustandsbestimmungseinheit (IS1, T2) zur Bestimmung des Schaltzustands des Endstufentransistors, die ein vom Schaltzustand des Endstufentransistors abhängiges Schaltzustandssignal (SZ) ausgibt,
- eine Einschaltsteuerlogikeinheit (ELE), die das Ansteuersignal und das Schaltzustandssignal (SZ) empfängt und in Abhängigkeit davon ein Ladestromsteuersignal (SL) erzeugt, und
- einen durch das Ladestromsteuersignal (SE) angesteuerten Schnellladetransistor (ST) zur Bereitstellung des zusätzlichen Ladestroms, der zwischen eine Versorgungsspannung (UV) und die Gate-Elektrode des Endstufentransistors eingeschleift ist.

4. Integrierter Schaltkreis nach Anspruch 3, **dadurch gekennzeichnet, dass** die Schaltzustandsbestimmungseinheit aufweist:
- einen zweiten Sensortransistor (T2), dessen Gate-Elektrode mit der Gate-Elektrode des Endstufentransistors verbunden ist, und
- eine zweite Sensorstromquelle (IS1), wobei die zweite Sensorstromquelle (IS1) in Serie mit der Drain-Source-Strecke des zweiten Sensortransistors (T2) zwischen die Versorgungsspannung und ein Bezugspotential, insbesondere Masse, eingeschleift ist und das Schaltzustandssignal an der Drain-Elektrode des zweiten Sensortransistors (T2) ansteht.

5. Integrierter Schaltkreis nach einem der vorhergehenden Ansprüche, **dadurch gekennzeichnet, dass** die Ausschaltsteuereinheit aufweist:
- einen Schnellentladefreigabetransistor (BTF),
- eine Schnellentladefreigabetransistoransteuereinheit (I4, T4, IV2) zur Ansteuerung des Schnellentladefreigabetransistors (BTF), die eine an der Basis-Elektrode des Schnellentladetransistors (BT) anstehende Spannung empfängt und den Schnellentladefreigabetransistor (BTF) in Abhängigkeit davon durchschaltet oder sperrt, und
- eine Schnellentladestromquelle (I3), wobei eine Drain-Source-Strecke des Schnellentladefreigabetransistors (BTF) und die Schnellentladestromquelle (I3) in Serie zwischen die Basis-Elektrode des Schnellentladetransistors (BT) und ein Bezugspotential, insbesondere Masse, eingeschleift sind.

6. Integrierter Schaltkreis nach einem der vorhergehenden Ansprüche, **dadurch gekennzeichnet, dass** die Ausschaltsteuereinheit aufweist:
- einen Integrationskondensator (C1) und
- eine Integrationsstromquelle (15), wobei der Integrationskondensator (C1) und die Integrationsstromquelle (I5) in Serie zwischen das Drainspannungssignal (DS) und ein Bezugspotential, insbesondere Masse, eingeschleift sind und ein Verbindungsknoten zwischen dem Integrationskondensator (C1) und der Integrationsstromquelle (15) mit der Basis-Elektrode des Schnellentladetransistors (BT) verbunden ist.

7. Integrierter Schaltkreis nach einem der vorhergehenden Ansprüche, **gekennzeichnet durch**
- einen Pull-Down-Widerstand (R1), der zwischen die Gate-Elektrode des Endstufentransistors und ein Bezugspotential, insbesondere Masse, eingeschleift ist, und
- eine Kompensationseinheit (R2, T5, T6, IM, IK), die einen durch den Pull-Down-Widerstand (R1) verursachten Strom von der Gate-Elektrode zum Bezugspotential kompensiert.

8. Integrierter Schaltkreis nach Anspruch 7, **dadurch gekennzeichnet, dass** die Kompensationseinheit aufweist:
- einen Sensorwiderstand (R2), dessen elektrische Eigenschaften im wesentlichen mit den elektrischen Eigenschaften des Pull-Down-Widerstands (R1) übereinstimmen,
- eine Spannungsfolgereinheit, welche die an dem Pull-Down-Widerstand anliegende Spannung hochohmig abgreift und niederohmig an den Sensorwiderstand anlegt,
- eine Strommesseinheit (IM), die den durch den Sensorwiderstand fließenden Strom misst, und
- eine gesteuerte Kompensationsstromquelle (IK) zur Einspeisung eines Kompensationsstromes in die Gate-Elektrode des Endstufentransistors.

## Claims

1. Integrated circuit with
- an MOS end-stage transistor (T1),
- a control terminal (TxD) for application of a drive control signal controlling switching-on and switching-off of the end-stage transistor (T1),
- a charging transistor (LT) which loads a gate electrode (GE) of the end stage (T1) with a charging current (I1) when the end-stage transistor (T1) is switched on,
- a discharging transistor (ET) which loads the gate electrode (GE) of the end-stage transistor (T1) with a discharging current (12) when the end-stage transistor (T1) is switched off and
- a switch-off control unit (ASE) which loads the gate electrode (GE) during a first time interval with an additional discharging current (IZE) when the end-stage transistor (T1) is switched off and subsequently to the first time interval switches off the additional discharging current (IZE), wherein the switch-off control unit (ASE) comprises:
- a voltage determining unit (T3, IS2) for determining the voltage at the drain electrode of the end-stage transistor (T1), which issues a drain voltage signal (DS) dependent on the voltage arising at the drain electrode of the end-stage transistor, wherein the voltage determining unit comprises:
- a first sensor transistor (T3), the gate electrode of which is connected with a supply voltage (UV), and
- a first sensor current source (IS2), wherein the drain source path of the first sensor transistor (T3) and the first sensor current source (IS2) are connected in series between the drain electrode of the end-stage transistor and a reference potential, particularly ground, and the drain voltage signal (DS) is present at the source electrode of the first sensor transistor (T3),
- a switch-off control logic unit (ALE) which receives the control signal and the drain voltage signal (DS) and generates a discharge control signal (SE) in dependence thereon,
- a transfer logic gate (TG) controllable in drive by the discharge control current signal and
- a bipolar rapid discharge transistor (BT), wherein the transfer logic gate (TG) is connected in series with the collector-emitter path of the rapid discharge transistor (BT) between the gate electrode of the end-stage transistor and a reference potential, particularly ground.

2. Integrated circuit according to claim 1, **characterised by** a switch-on control unit (ESE) which loads the gate electrode (GE) during a second time interval with an additional charging current (IZL) when the end-stage transistor (T1) is switched on and subsequently to the second time interval switches off the additional charging current (IZL).

3. Integrated circuit according to claim 2, **characterised in that** the switch-on control unit comprises:
- a switching state determining unit (IS1, T2) for determining the switching state of the end-stage transistor, which issues a switching state signal (SZ) dependent on the switching state of the end-stage transistor,
- a switch-on control logic unit (ELE), which receives the drive control signal and the switching stage signal (SZ) and generates a charging current control signal (SL) in dependence thereon and
- a rapid charging transistor (ST), which is controlled in drive by the charging current control signal (SE), for providing the additional charging current, which is connected between a supply voltage (UV) and the gate electrode of the end-stage transistor.

4. Integrated circuit according to claim 3, **characterised in that** the switching state determining unit comprises:
- a second sensor transistor (T2), the gate electrode of which is connected with the gate electrode of the end-stage transistor, and
- a second sensor current source (IS1), wherein the second sensor current source (IS1) is connected in series with the drain-source path of the second sensor transistor (T2) between the supply voltage and a reference potential, particularly ground, and the switching state signal is present at the drain electrode of the second sensor transistor (T2).

5. Integrated circuit according to one of the preceding claims, **characterised in that** the switch-off control unit comprises:
- a rapid discharge release transistor (BTF),
- a rapid discharge release transistor drive control unit (14, T4, IV2) for drive control of the rapid discharge release transistor (BTF), which receives a voltage present at the base electrode of the rapid discharge transistor (BT) and switches through or blocks the rapid discharge release transistor (BTF) in dependence thereon, and
- a rapid discharge current source (13), wherein a drain-source path of the rapid discharge release transistor (BTF) and the rapid discharge current source (13) are connected in series between the base electrode of the rapid discharge transistor (BTF) and a reference potential, particularly ground.

6. Integrated circuit according to one of the preceding claims, **characterised in that** the switch-off control unit comprises:
- an integration capacitor (C1) and
- an integration current source (15), wherein the integration capacitor (C1) and the integration current source (I5) are connected in series between the drain voltage signal (DS) and a reference potential, particularly ground, and a connecting junction is connected between the integration capacitor (C1) and the integration current source (I5) with the base electrode of the rapid discharge transistor (BT).

7. Integrated circuit according to one of the preceding claims, **characterised by**
- a pull-down resistor (R1), which is connected between the gate electrode of the end-stage transistor and a reference potential, particularly ground, and
- a compensation unit (R2, T5, T6, IM, IK), which provides compensation for a current, which is caused by the pull-down resistor (R1), from the gate electrode to the reference potential.

8. Integrated circuit according to claim 7, **characterised in that** the compensation unit comprises:
- a sensor resistor (R2), the electrical characteristics of which substantially correspond with the electrical characteristics of the pull-down resistor (R1),
- a voltage tracking unit which taps off with high resistance the voltage lying at the pull-down resistor and applies it with low resistance to the sensor resistor,
- a current measuring unit (IM), which measures the current flowing through the sensor resistor, and
- a controlled compensation current source (IK) for feeding a compensation current to the gate electrode of the end-stage transistor.

## Revendications

1. Circuit intégré comprenant :
. un transistor MOS de dernier étage (T1),
. une borne de commande (TxD) pour l'application d'un signal de commande commandant une mise sous tension et une mise hors tension du transistor de dernier étage (T1),
. un transistor de charge (LT) qui, lors de la mise sous tension du transistor de dernier étage (T1), alimente une grille (GE) du transistor de dernier étage (T1) avec un courant de charge (I1),
. un transistor ballast (ET) qui, lors de la mise hors tension du transistor de dernier étage (T1), alimente la grille (GE) du transistor de dernier étage (T1) avec un courant de décharge (12), et
· une unité de commande de mise hors tension (ASE) qui, lors de la mise hors tension du transistor de dernier étage (T1), alimente la grille (GE) avec un courant de décharge supplémentaire (IZE) durant un premier intervalle de temps et, suite à ce premier intervalle de temps, coupe le courant de décharge supplémentaire (IZE), unité de commande de mise hors tension (ASE) qui comprend :
- une unité d'identification de tension (T3, IS2) pour identifier la tension au niveau du collecteur du transistor de dernier étage (T1), qui émet un signal de tension de collecteur (DS) dépendant de la tension existant au niveau du collecteur du transistor de dernier étage, cette unité d'identification de tension présentant :
· un premier transistor de capteur (T3) dont la grille est reliée à une tension d'alimentation (UV), et
. une première source de courant de capteur (IS2), l'espace collecteur-émetteur du premier transistor de capteur (T3) et la première source de courant de capteur (IS2) étant insérées en série entre le collecteur du transistor de dernier étage et un potentiel de référence, plus particulièrement une masse, et le signal de tension de collecteur (DS) existant à l'émetteur du premier transistor de capteur (T3),
. une unité logique de commande de mise hors tension (ALE), qui reçoit le signal de commande et le signal de tension de collecteur (DS) et génère en fonction de ceux-ci un signal de commande de courant de décharge (SE),
. une grille de transmission (TG) commandée par le signal de courant de décharge et
. un transistor ballast bipolaire rapide (BT), la grille de transmission (TG) étant insérée en série avec l'espace collecteur-émetteur du transistor ballast rapide (BT) entre la grille du transistor de dernier étage et un potentiel de référence, en particulier une masse.

2. Circuit intégré selon la revendication 1, **caractérisé par** une unité de commande de mise sous tension (ESE) qui, lors de la mise sous tension du transistor de dernier étage (T1), alimente la grille (GE) par un courant de charge supplémentaire (IZL) durant un deuxième intervalle de temps, et, suite à ce deuxième intervalle de temps, coupe le courant de charge supplémentaire (IZL).

3. Circuit intégré selon la revendication 2, **caractérisé en ce que** l'unité de commande de mise sous tension comprend :
. une unité d'identification d'état de commutation (IS1, T2) pour identifier l'état de commutation du transistor de dernier étage, qui émet un signal d'état de commutation (SZ) dépendant de l'état de commutation du transistor de dernier étage,
. une unité logique de commande de mise sous tension (ELE), qui reçoit le signal de commande et le signal d'état de commutation (SZ) et génère en fonction de ceux-ci un signal de commande de courant de charge (SL) et
. un transistor de charge rapide (ST) commandé par le signal de commande de courant de charge (SE) pour l'alimentation en courant de charge supplémentaire, qui est inséré entre une tension d'alimentation (UV) et la grille du transistor de dernier étage.

4. Circuit intégré selon la revendication 3, **caractérisé en ce que** l'unité d'identification d'état de commutation présente :
. un deuxième transistor de capteur (T2), dont la grille est reliée à la grille du transistor de dernier étage, et
. une deuxième source de courant de capteur (IS1), la deuxième source de courant de capteur (IS1) étant insérée en série avec l'espace collecteur-émetteur du deuxième transistor de capteur (T2) entre la tension d'alimentation et un potentiel de référence, plus particulièrement une masse, et le signal d'état de commutation existant au collecteur du deuxième transistor de capteur (T2).

5. Circuit intégré selon l'une quelconque des revendications précédentes, **caractérisé en ce que** l'unité de commande de mise hors tension présente :
. un transistor de libération de décharge rapide (BTF),
. une unité de commande de transistor de libération de décharge rapide (14, T4, IV2) pour commander le transistor de libération de décharge rapide (BTF), qui reçoit une tension existant au niveau de la base du transistor ballast rapide (BT) et commute ou bloque le transistor de libération de décharge rapide (BTF) en fonction de celle-ci, et
. une source de courant de décharge rapide (13), un espace collecteur-émetteur du transistor de libération de décharge rapide (BTF) et la source de courant de décharge rapide (13) étant insérés en série entre la base du transistor ballast rapide (BT) et un potentiel de référence, plus particulièrement une masse.

6. Circuit intégré selon l'une quelconque des revendications précédentes, **caractérisé en ce que** l'unité de commande de mise hors tension présente :
. un condensateur d'intégration (C1) et
. une source de courant d'intégration (15), le condensateur d'intégration (C1) et la source de courant d'intégration (15) étant insérés en série entre le signal de tension de collecteur (DS) et un potentiel de référence, plus particulièrement une masse, et un noeud de connexion entre le condensateur d'intégration (C1) et la source de courant d'intégration (I5) étant relié à la base du transistor ballast rapide (BT).

7. Circuit intégré selon l'une quelconque des revendications précédentes, **caractérisé par** :
. une résistance d'excursion basse (R1), insérée entre la grille du transistor de dernier étage et un potentiel de référence, plus particulièrement une masse, et
· une unité de compensation (R2, T5, T6, IM, IK) qui compense un courant causé par la résistance d'excursion basse (R1) de la grille au potentiel de référence.

8. Circuit intégré selon la revendication 7, **caractérisé en ce que** l'unité de compensation présente :
. une résistance de capteur (R2) dont les caractéristiques électriques correspondent sensiblement aux caractéristiques électriques de la résistance d'excursion basse (R1),
. une suiveuse de tension qui prélève sous grande résistance ohmique la tension existant au niveau de la résistance d'excursion basse et l'applique sous faible résistance ohmique au niveau de la résistance de capteur,
. une unité de mesure du courant (IM), qui mesure le courant passant par la résistance de capteur, et
. une source de courant de compensation (IK) commandée pour la fourniture d'un courant de compensation à la grille du transistor de dernier étage.
